(19) Europäisches Patentamt
European Patent Office
Office européen des brevets

(11) **EP 4 030 230 A1**

(12) **EUROPEAN PATENT APPLICATION**

(43) Date of publication:
**20.07.2022 Bulletin 2022/29**

(21) Application number: **21152056.4**

(22) Date of filing: **18.01.2021**

(51) International Patent Classification (IPC):
**G02F 1/35** *(2006.01)*    **G03F 1/00** *(2012.01)*
**G03F 1/50** *(2012.01)*    **G02F 1/365** *(2006.01)*
**G03F 7/20** *(2006.01)*    **H01S 3/00** *(2006.01)*

(52) Cooperative Patent Classification (CPC):
**G03F 7/70616; G02F 1/353; G02F 1/365;
G03F 7/70625; G03F 7/70633; G03F 9/7065;
H01S 3/0092**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **UEBEL, Patrick Sebastian
5500 AH Veldhoven (NL)**

• **PONGERS, Willem Richard
5500 AH Veldhoven (NL)**
• **BAUERSCHMIDT, Sebastian Thomas
5500 AH Veldhoven (NL)**
• **GÖTZ, Peter Maximilian
5500 AH Veldhoven (NL)**
• **VAN DEN OETELAAR, Ludovicus
5500 AH Veldhoven (NL)**

(74) Representative: **ASML Netherlands B.V.
Corporate Intellectual Property
P.O. Box 324
5500 AH Veldhoven (NL)**

(54) **METHODS AND APPARATUS FOR PROVIDING A BROADBAND LIGHT SOURCE**

(57) Methods and apparatus for generating broadband radiation. The apparatus comprises a pump source configured to generate pump radiation comprising a plurality of radiation pulses having a pulse energy of 2.5 µJ or less; The apparatus comprises a hollow core fiber comprising a hollow core and a cladding surrounding the hollow core, the hollow core having a pressurized gas therein, and the hollow core fiber being arranged to receive, at an input end, the pump radiation. One or more of a diameter of the hollow core and a pressure of the gas is configured such that the radiation pulse has a soliton order that is higher than 16 so as to broaden a spectrum of the pump radiation using modulation instability as the pump radiation propagates along the hollow-core fiber, for providing output broadband radiation from an output end of the hollow core fiber.

**EP 4 030 230 A1**

**Fig. 8**

**Description**

Field

The present invention relates to radiation sources for providing broadband output radiation. In particular, it relates to broadband radiation sources comprising a hollow core fiber having a pressurized gas therein, configured to spectrally broaden received input radiation.

Background

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer). The projected pattern may form part of a process to fabricate a structure onto the substrate.

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, it is desirable to make frequent measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

In addition, other operations are important in lithographic processes, such as alignment and levelling of the wafer within the lithographic apparatus.

Broadband radiation sources may be used in a number of lithographic processes, for example alignment, levelling and the measurement of overlay. It is therefore desirable to develop and improve broadband radiation sources.

Summary

The inventors have appreciated that a broadband radiation source may comprise a pump laser configured to provide laser radiation pulses, and a hollow core fiber, such as a hollow core photonic crystal fiber (HC-PCF), configured to receive the laser radiation pulses and to broaden the spectrum thereof as they propagate through the fiber.

According to a first aspect of the invention there is provided a radiation source for generating broadband radiation. The radiation source comprises a pump source configured to generate pump radiation comprising a plurality of radiation pulses having a pulse energy of 2.5 $\mu$J or less. The radiation source further comprises a hollow core fiber comprising a hollow core and a cladding surrounding the hollow core. The hollow core has a pressurized gas therein, and is arranged to receive, at an input end, the pump radiation. One or more of a diameter of the hollow core and a pressure of the gas is configured such that the radiation pulse has a soliton order that is higher than 16 so as to broaden a spectrum of the pump radiation using modulation instability as the pump radiation propagates along the hollow-core fiber, for providing output broadband radiation from an output end of the hollow core fiber.

Optionally, the diameter of the hollow core may be less than 30 $\mu$m, less than 20 $\mu$m or less than 10 $\mu$m.

Optionally, the diameter of the hollow core may be in a range from 16 $\mu$m to 22 $\mu$m.

Optionally, the pulse duration may be in a range from 100 s to 500 fs.

Optionally, the pressure of the gas may be configured to provide a spectrum of the output broadband radiation having a low-wavelength cut-off in a range from 350 nm to 450 nm, given a particular hollow core diameter.

Optionally, the pressure of the gas may be in a range from 20 bar to 40 bar.

Optionally, the pressure of the gas may be determined based on a zero-dispersion wavelength of the hollow core fiber.

Optionally, the zero-dispersion wavelength may be determined based on the formula:

$$\beta_2(\lambda = \lambda_{\mathrm{ZDW}}) \equiv 0$$

$$\text{with } \beta_2 = \frac{\partial^2 \beta}{\partial \omega^2} \text{ and } \omega = 2\pi\frac{c}{\lambda}$$

where $\beta$ is a propagation constant, $\lambda$ is wavelength and $c$ is the speed of light in vacuum.

Optionally, the zero-dispersion wavelength may be in a range from 700 nm to 1000 nm;

Optionally, the pressure of the gas may be determined based on a phase-matching wavelength of the hollow core fiber.

Optionally, the phase-matching wavelength $\lambda_{\mathrm{PM}}$ may be determined based on the formula:

$$\beta_{\mathrm{PM}}(\lambda = \lambda_{\mathrm{PM}}) - \beta_{\mathrm{sol}}(\omega) = 0$$

with

$$\beta_{\mathrm{sol}}(\omega) \equiv \beta(\omega_{\mathrm{pump}}) + \beta_1(\omega_{\mathrm{pump}}) \cdot [\omega - \omega_{\mathrm{pump}}] + \frac{\gamma P_c}{2}$$

and

$$\omega_{\mathrm{pump}} = 2\pi\frac{c}{\lambda}, \beta_1 = \frac{\partial \beta}{\partial \omega}$$

where $\beta_{\mathrm{PM}}$ is a linear propagation constant at the phase matching wavelength, $\beta_{\mathrm{sol}}$ is a propagation constant of a soliton at pump frequency $\omega_{pump}$, $c$ is the speed of light in vacuum, $y$ is a nonlinear parameter, and $P_c$ is a peak power of a compressed soliton.

Optionally, the phase-matching wavelength may be in a range from 300 to 700 nm.

Optionally, when a change is made to the diameter of the hollow core, the relations between the former (base) and changed (new) hollow core diameters, the energy of the radiation pulses, and the pressure of the gas forming the working medium inside the hollow core, may be expressed according to the formula

$$E_{new} = E_{base}\left(\frac{D_{new}}{D_{base}}\right)^2 \frac{p_{base}}{p_{new}}$$

Optionally, the pump source may comprise a seed laser configured to provide seed radiation pulses, and a fiber amplifier configured to receive and amplify the seed radiation pulses. The pump radiation may be provided to the hollow core fiber.

Optionally, the pump source may further comprise a pulse compressor located downstream, and optionally directly downstream, of the fiber amplifier.

Optionally, the pulse compressor may comprise one or more prism pairs.

Optionally, the seed laser pulses may have a first repetition rate. The output broadband radiation of the radiation source may comprise pulses with a second repetition rate, wherein the first repetition rate is substantially equal to the second repetition rate.

Optionally, the pump source may comprise only a single fiber amplifier.

Optionally, the hollow core fiber may be a hollow core photonic crystal fiber, HC-PCF.

Optionally, the hollow core of the photonic crystal fibre may be surrounded by a cladding comprising a plurality of capillaries.

Optionally, a thickness of a wall portion of the capillaries in the HC-PCF may be 200 nm or less.

Optionally, the HC-PCF may be a single-ring HC-PCF.

According to another aspect of the current disclosure, there is provided a hollow core photonic crystal fiber (HC-PCF) for receiving one or more pulses of pump radiation having an energy of 2.5 µJ or less. The HC-PCF is configured such that the one or more pulses of pump radiation have a soliton order that is higher than 16 so as to broaden a spectrum of the pump radiation using modulation instability as the pump radiation propagates along the fiber. The fiber comprises a hollow core having a diameter in a range from 16 µm to 22 µm, and a cladding surrounding the hollow core. The hollow core is configured to receive a pressurized gas therein.

Optionally, the HC-PCF may be a single-ring HC-PCF.

Optionally, a thickness of a wall portion of the capillaries in the HC-PCF may be around 200 nm or less.

Optionally, the hollow core may be filled with a gas at a pressure in a range from 20 bar to 40 bar.

According to another aspect of the current disclosure, there is provided a radiation source for generating broadband radiation. The radiation source comprises a pump source configured to generate pump radiation comprising a plurality of radiation pulses having a pulse energy of 2.5 µJ or less, and a hollow core fiber comprising a hollow core and a cladding surrounding the hollow core. The hollow core has a pressurized gas therein, and the hollow core fiber is arranged to receive, at an input end, the pump radiation and to emit, at an output end, output broadband radiation. A diameter of the hollow core is in a range from 16 µm to 22 µm, and the pump radiation pulses has a soliton order that is higher than 16.

According to another aspect of the current disclosure, there is provided a radiation source for generating broadband radiation. The radiation source comprises a pump source configured to generate pump radiation comprising a plurality of radiation pulses having a pulse energy of 2.5 µJ or less, and hollow core fiber comprising a hollow core and a cladding surrounding the hollow core, the hollow core configured to have a pressurized gas therein. The hollow core fiber is arranged to receive, at an input end, the pump radiation. The radiation source comprises a reservoir configured to control and deliver the pressurized gas to the hollow core fiber. One or more of a diameter of the hollow core and a pressure of the pressurized gas is configured such that the radiation pulse has a soliton order that is higher than 16 so as to broaden a spectrum of the pump radiation using modulation instability as the pump radiation propagates along the hollow-core fiber, for providing output broadband radiation from an output end of the hollow core fiber.

According to another aspect of the current disclosure there is provided a lithographic apparatus comprising the radiation source as described above, and/or comprising the HC-PCF as described above.

According to another aspect of the current disclosure there is provided a litho-cell comprising the lithographic apparatus as described above.

According to another aspect of the current disclosure there is provided a method for generating broadband radiation. The method comprises generating, by a pump source, pump radiation comprising a plurality of radiation pulses having a pulse energy of 2.5 µJ or less, and receiving the pump radiation at an input end of a hollow core fiber, the hollow core fiber comprising a hollow core and a cladding surrounding the hollow core. The hollow core has a pressurized gas therein. One or more of a diameter of the hollow core and a pressure of the gas are configured such that radiation pulse has a soliton order that is higher than 16 so as to broaden a spectrum of the pump radiation using modulation instability as the pump radiation propagates along the hollow-core fiber. The method provides output broadband radiation from an output end of the hollow core fiber.

According to another aspect of the current disclosure, there is provided a method for generating broadband radiation. The method comprises generating, by a pump source, pump radiation comprising a plurality of radiation pulses having a pulse energy of 2.5 µJ or less, and receiving the pump radiation at an input end of a hollow core fiber. The hollow core fiber comprises a hollow core and a cladding surrounding the hollow core. The hollow core has a diameter in a range from 16 µm to 22 µm and has a pressurized gas therein. The hollow core fiber is configured such that the radiation pulses have a soliton order that is higher than 16 so as to broaden a spectrum of the pump radiation using modulation instability as the pump radiation propagates along the hollow-core fiber. The method comprises providing output broadband radiation from an output end of the hollow core fiber.

Brief description of drawings

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;

- Figure 3 depicts a schematic representation of holistic lithography, representing a cooperation between three key technologies to optimize semiconductor manufacturing;
- Figure 4 depicts a schematic representation of a cross sectional view of a hollow-core optical fiber in a transverse plane;
- Figure 5 depicts a schematic representation of a radiation source for providing broadband output radiation;
- Figure 6(a) depicts a schematic representation of a cross sectional view of a Kagome fiber in a transverse plane;
- Figure 6(b) depicts a schematic representation of a cross sectional view of a hollow core fibre comprising a single ring of tubular capillaries, in a transverse plane.
- Figure 7 depicts a schematic representation of components of a pump radiation source;
- Figure 8 depicts a schematic representation of a radiation source for providing broadband output radiation; and
- Figure 9 depicts an example graph of a relation between core diameter, gas pressure, and pulse energy in a radiation source for a given zero dispersion wavelength.

Detailed description

Generally, disclosed herein are methods and apparatus aimed at simplifying a broadband radiation source. More specifically, the inventors have appreciated that by increasing the non-linear properties of a hollow core photonic crystal fiber (HC-PCF), the input energy from the pump laser may be reduced, whilst still providing the required broadband spectrum of the radiation emitted from the radiation source. This has a number of advantages, not least that the pump laser may include fewer amplification stages, greatly reducing cost.

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

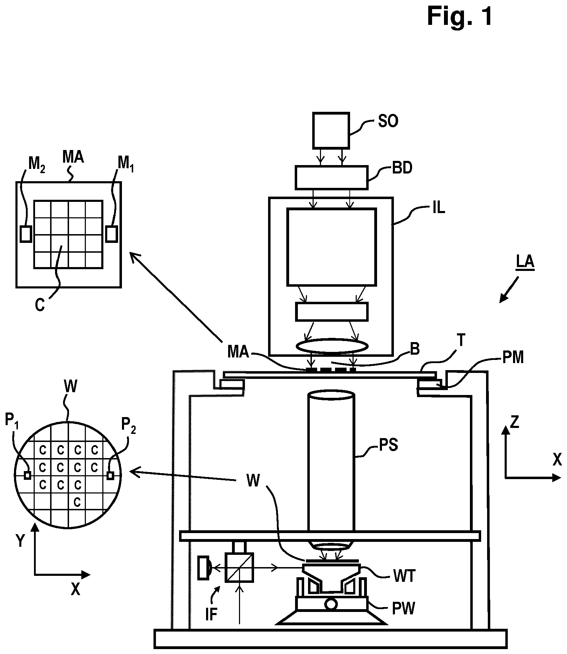

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage.

The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

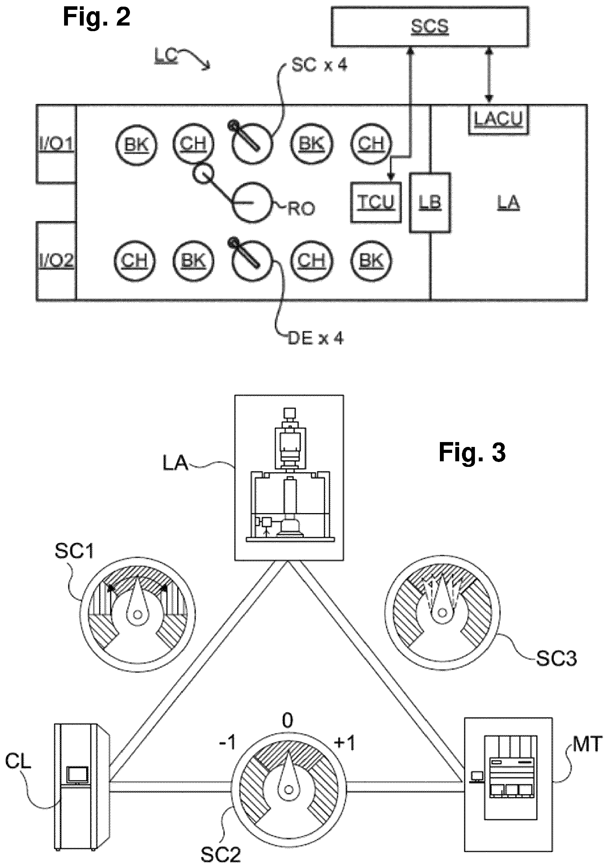

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray, extreme ultraviolet and visible to near-IR wavelength range.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

High quality broadband radiation, for example supercontinuum radiation, may be difficult to generate. One method for generating broadband radiation may be to broaden high-power narrow band or single frequency input radiation, for example making use of non-linear, higher order effects. The input radiation (which may be produced using a laser) may be referred to as pump radiation. Alternatively, the input radiation may be referred to as seed radiation. To obtain high power radiation for broadening effects, radiation may be confined into a small area so that strongly localised high intensity radiation is achieved. In those areas, the radiation may interact with spectral broadening structures and/or materials forming a non-linear medium so as to create broadband output radiation. In the high intensity radiation areas, different materials and/or structures may be used to enable and/or improve radiation broadening by providing a suitable non-linear medium.

In some implementations, the broadband output radiation is created in a photonic crystal fiber. (PCF). In several embodiments, such a photonic crystal fiber has microstructures around its fiber core assisting in confining radiation that travels through the fiber in the fiber core. The fiber core can be made of a solid material that has non-linear properties and that is capable of generating broadband radiation when high intensity pump radiation is transmitted through the fiber core. Although it is feasible to generate broadband radiation in solid core photonic crystal fibers, there may be a few disadvantages of using a solid material. For example, if UV radiation is generated in the solid core, this radiation might not be present in the output spectrum of the fiber because the radiation is absorbed by most solid material.

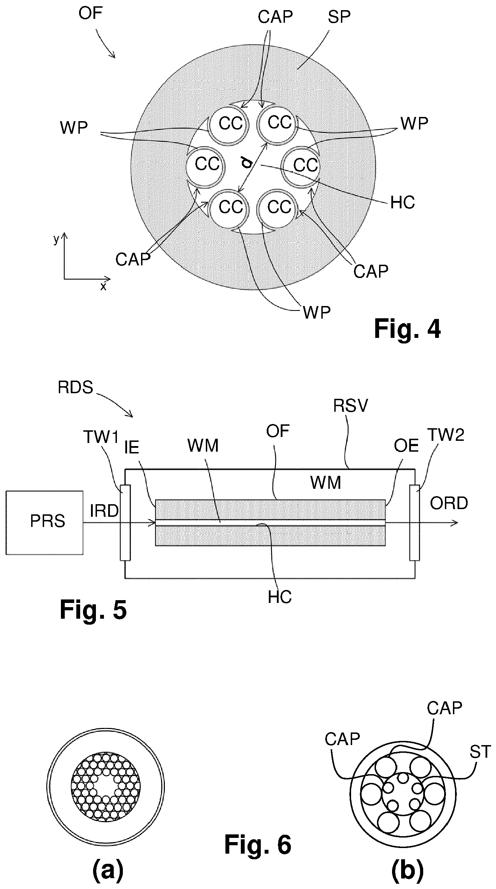

In some implementations, as discussed further below with reference to Figure 5, methods and apparatus for broadening input radiation may use a fiber for confining input radiation, and for broadening the input radiation to output broadband radiation. The fiber may be a hollow core fiber, and may comprise internal structures to achieve effective guiding and confinement of radiation in the fiber. The fiber may be a hollow core photonic crystal fiber (HC-PCF), which is particularly suitable for strong radiation confinement, predominantly inside the hollow core of the fiber, achieving high radiation intensities. The hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light.

Some embodiments relate to a new design of such a broadband radiation source comprising an optical fiber. The optical fiber is a hollow-core, photonic crystal fiber (HC-PCF). In particular, the optical fiber may be a hollow-core, photonic crystal fiber of a type comprising anti-resonant structures for confinement of radiation. Such fibers comprising anti-resonant structures are known in the art as anti-resonant fibers, tubular fibers, single-ring fibers, negative curvature fibers or inhibited coupling fibers. Various different designs of such fibers are known in the art. Alternatively, the optical fiber may be photonic bandgap fibers (HC-PBFs, for example a Kagome fiber).

A number of types of HC-PCFs can be engineered, each based on a different physical guidance mechanism. Two such HC-PCFs include: hollow-core photonic bandgap fibers (HC-PBFs) and hollow-core anti-resonant reflecting fibers (HC-ARFs). Detail on the design and manufacture of HC-PCFs can be found in US patent US2004/015085A1 (for HC-PBFs) and International PCT patent application WO2017/032454A1 (for Hollow Core anti-resonant reflecting fibers), which are incorporated herein by reference. Figure 6(a) shows a Kagome fiber, comprising a Kagome lattice structure.

An example of an optical fiber for use in the radiation source is now described with reference to Figure 4, which is a schematic cross sectional view of the optical fiber OF in a transverse plane. Further embodiments similar to the practical example of the fiber of Figure 4 are disclosed in WO2017/032454A1.

The optical fiber OF comprises an elongate body, defining a length of the fiber and which is longer in one dimension compared to the other two dimensions of the fiber OF. This longer dimension may be referred to as an axial direction and may define an axis of the optical fiber OF. The two other dimensions define a plane which may be referred to as a transverse plane. Figure 4 shows a cross-section of the optical fiber OF in this transverse plane (i.e. perpendicular to the axis), which is labelled as the x-y plane. The transverse cross-section of the optical fiber OF may be substantially constant along the fiber axis.

It will be appreciated that the optical fiber OF has some degree of flexibility and therefore the direction of the axis will not, in general, be uniform along the length of the optical fiber OF. The terms such as the optical axis, the transverse cross-section and the like will be understood to mean the local optical axis, the local transverse cross-section and so on. Furthermore, where components are described as being cylindrical or tubular these terms will be understood to encompass such shapes that may have been distorted as the optical fiber OF is flexed.

The optical fiber OF may have any length and it will be appreciated that the length of the optical fiber OF may be dependent on the application. The optical fiber OF may have a length between 1 cm and 10 m, for example, the optical fiber OF may have a length between 10 cm and 100 cm.

The optical fiber OF comprises: a hollow core COR; a cladding portion surrounding the hollow core HC; and a support portion SP surrounding and supporting the cladding portion. The optical fiber OF may be considered to comprise a body (comprising the cladding portion and the support portion SP) having a hollow core HC. The cladding portion comprises a plurality of anti-resonance elements for guiding radiation through the hollow core HC. In particular, the plurality of anti-resonance elements are arranged to confine radiation that propagates through the optical fiber OF predominantly inside the hollow core HC and to guide the radiation along the optical fiber OF. The hollow core HC of the optical fiber OF may be disposed substantially in a central region of the optical fiber OF, so that the axis of the optical fiber OF may also define an axis of the hollow core HC of the optical fiber OF.

The cladding portion comprises a plurality of anti-resonance elements for guiding radiation propagating through the optical fiber OF. In particular, in this embodiment, the cladding portion comprises a single ring of six tubular capillaries CAP. Each of the tubular capillaries CAP acts as an anti-resonance element.

The capillaries CAP may also be referred to as tubes. The capillaries CAP may be circular in cross section, or may have another shape. Each capillary CAP comprises a generally cylindrical wall portion WP that at least partially defines the hollow core HC of the optical fiber OF and separates the hollow core HC from a capillary cavity CC. It will be appreciated that the wall portion WP may act as an anti-reflecting Fabry-Perot resonator for radiation that propagates through the hollow core HC (and which may be incident on the wall portion WP at a grazing incidence angle). The thickness of the wall portion WP may be suitable so as to ensure that reflection back into the hollow core HC is generally enhanced whereas transmission into the capillary cavity CC is generally supressed. In some embodiments, the capillary wall portion WP may have a thickness between 0.01 - 10.0 μm.

It will be appreciated that, as used herein, the term cladding portion is intended to mean a portion of the optical fiber OF for guiding radiation propagating through the optical fiber OF (i.e. the capillaries CAP which confine said radiation within the hollow core COR). The radiation may be confined in the form of transverse modes, propagating along the fiber axis.

The support portion is generally tubular and supports the six capillaries CAP of the cladding portion. The six capillaries CAP are distributed evenly around an inner surface if the inner support portion SP. The six capillaries CAP may be described as being disposed in a generally hexagonal formation.

The capillaries CAP are arranged so that each capillary is not in contact with any of the other capillaries CAP. Each of the capillaries CAP is in contact with the inner support portion SP and spaced apart from adjacent capillaries CAP in the ring structure. Such an arrangement may be beneficial since it may increase a transmission bandwidth of the optical fiber OF (relative, for example, to an arrangement wherein the capillaries are in contact with each other). Alternatively, in some embodiments, each of the capillaries CAP may be in contact with adjacent capillaries CAP in the ring structure.

The six capillaries CAP of the cladding portion are disposed in a ring structure around the hollow core COR. An inner surface of the ring structure of capillaries CAP at least partially defines the hollow core HC of the optical fiber OF. The diameter d of the hollow core HC (which may be defined as the smallest dimension between opposed capillaries, indicated by arrow d) may be between 10 and 1000 μm and may have other diameters as set out in exemplary arrangements described below. The diameter d of the hollow core HC may affect the mode field diameter, impact loss, dispersion, modal plurality, and non-linearity properties of the hollow core optical fiber OF.

In this embodiment, the cladding portion comprises a single ring arrangement of capillaries CAP (which act as anti-resonance elements). Therefore, a line in any radial direction from a center of the hollow core HC to an exterior of the optical fiber OF passes through no more than one capillary CAP.

It will be appreciated that other embodiments may be provided with different arrangements of anti-resonance elements. These may include arrangements having multiple rings of anti-resonance elements and arrangements having nested anti-resonance elements. Furthermore, although the embodiment shown in Figure 4 comprises a ring of six capillaries, in other embodiments, one or more rings comprising any number of anti-resonance elements (for example 4, 5, 6, 7, 8, 9, 10, 11 or 12 capillaries) may be provided in the cladding portion.

Figure 6(b) shows a modified embodiment of the above discussed HC-PCFs with a single ring of tubular capillaries. In the example of Figure 6(b) there are two coaxial rings of tubular capillaries CAP. For holding the inner and outer rings of tubular capillaries CAP, a support tube ST may be included in the HC-PCF. The support tube may be made of silica.

The tubular capillaries of the examples of Figure 4 and Figures 6 (a) and (b) may have a circular cross-sectional shape. Other shapes are also possible for the tubular capillaries, like elliptical or polygonal cross-sections. Additionally, the solid material of the tubular capillaries of the examples of Figure 4 and Figures 6 (a) and (b) may comprise plastic material, like PMA, glass, like silica, or soft glass.

Figure 5 depicts a radiation source RDS for providing broadband output radiation. The radiation source RDS comprises a pulsed pump radiation source PRS, such as a laser or any other type of source that is capable of generating short pulses of radiation having a desired length and energy level; an optical fiber OF (for example of the type shown in Figure 4) with a hollow core HC; and a working medium WM (for example a gas) disposed within the hollow core HC. Although in Figure 5 the radiation source RDS comprises the optical fiber OF shown in Figure 4, in alternative embodiments other types of hollow core optical fiber may be used.

The pulsed pump radiation source PRS is configured to provide input, or pump, radiation IRD. The hollow core HC of the optical fiber OF is arranged to receive the input radiation IRD from the pulsed pump radiation source PRS, and broaden it to provide output radiation ORD. The working medium WM enables the broadening of the frequency range of the received input radiation IRD so as to provide broadband output radiation ORD.

The radiation source RDS further comprises a reservoir RSV. The optical fiber OF is disposed inside the reservoir RSV. The reservoir RSV may also be referred to as a housing, container or gas cell. The reservoir RSV is configured to contain the working medium WM. The reservoir RSV may comprise one or more features, known in the art, for controlling, regulating, and/or monitoring the composition of the working medium WM (which may be a gas) inside the reservoir RSV. The reservoir RSV may comprise a first transparent window TW1. In use, the optical fiber OF is disposed inside the reservoir RSV such that the first transparent window TW1 is located proximate to an input end IE of the optical fiber OF. The first transparent window TW1 may form part of a wall of the reservoir RSV. The first transparent window TW1 may be transparent for at least the received input radiation frequencies, so that received input radiation IRD (or at least a large portion thereof) may be coupled into the optical fiber OF located inside reservoir RSV. It will be appreciated that optics (not shown) may be provided for coupling the input radiation IRD into the optical fiber OF.

The reservoir RSV comprises a second transparent window TW2, forming part of a wall of the reservoir RSV. In use, when the optical fiber OF is disposed inside the reservoir RSV, the second transparent window TW2 is located proximate to an output end OE of the optical fiber OF. The second transparent window TW2 may be transparent for at least the frequencies of the broadband output radiation ORD of the radiation source RDS.

Alternatively, in another embodiment, the two opposed ends of the optical fiber OF may be placed inside different reservoirs. The optical fiber OF may comprise a first end section configured to receive input radiation IRD, and a second end section for outputting broadband output radiation ORD. The first end section may be placed inside a first reservoir, comprising a working medium WM. The second end section may be placed inside a second reservoir, wherein the second reservoir may also comprise a working medium WM. The functioning of the reservoirs may be as described in relation to Figure 5 above. The first reservoir may comprise a first transparent window, configured to be transparent for input radiation IRD. The second reservoir may comprise a second transparent window configured to be transparent for broadband output broadband radiation ORD. The first and second reservoirs may also comprise a sealable opening to permit the optical fiber OF to be placed partially inside and partially outside the reservoir, so that a gas can be sealed inside the reservoir. The optical fiber OF may further comprise a middle section not contained inside a reservoir. Such an arrangement using two separate gas reservoirs may be particularly convenient for embodiments wherein the optical fiber OF is relatively long (for example when the length is more than 1 m). It will be appreciated that for such arrangements which use two separate gas reservoirs, the two reservoirs (which may comprise one or more features, known in the art, for controlling, regulating, and/or monitoring the composition of a gas inside the two reservoirs) may be considered to provide an apparatus for providing the working medium WM within the hollow core HC of the optical fiber OF.

In this context a window may be transparent for a frequency of at least 50%, 75%, 85%, 90%, 95%, or 99% of incident radiation of that frequency on the window is transmitted through the window.

Both the first TW1 and the second TW2 transparent windows may form an airtight seal within the walls of the reservoir RSV so that the working medium WM (which may be a gas) may be contained within the reservoir RSV. It will be appreciated that the gas WM may be contained within the reservoir RSV at a pressure different to the ambient pressure of the reservoir RSV.

The working medium WM may comprise a noble gas such as Argon, Krypton, and Xenon, a Raman active gas such as Hydrogen, Deuterium and Nitrogen, or a gas mixture such as an Argon/Hydrogen mixture, a Xenon/Deuterium mixture, a Krypton/Nitrogen mixture, or a Nitrogen/Hydrogen mixture. Depending on the type of working medium WM, the nonlinear optical processes can include modulational instability (MI), soliton self-compression, soliton fission, Kerr effect, Raman effect and dispersive wave generation, details of which are described in WO2018/127266A1 and US9160137B1 (both of which are hereby incorporated by reference). Since the dispersion of the working medium WM can be tuned by varying the working medium WM pressure in the reservoir RSV (i.e. gas cell pressure), the generated broadband pulse dynamics and the associated spectral broadening characteristics can be adjusted so as to optimize the frequency conversion

In one implementation, the working medium WM may be disposed within the hollow core HC at least during receipt of input radiation IRD for producing broadband output radiation ORD. It will be appreciated that, while the optical fiber OF is not receiving input radiation IRD for producing broadband output radiation, the gas WM may be wholly or partially absent from the hollow core COR.

In order to achieve frequency broadening high intensity radiation may be desirable. An advantage of having a hollow core optical fiber OF is that it may achieve high intensity radiation through strong spatial confinement of radiation propagating through the optical fiber OF, achieving high localised radiation intensities. The radiation intensity inside the optical fiber OF may be high, for example due to high received input radiation intensity and/or due to strong spatial confinement of the radiation inside the optical fiber OF. An advantage of hollow core optical fibers is that they can guide radiation having a broader wavelength range than solid-core fibers and, in particular, hollow core optical fibers can guide radiation in both the ultraviolet and infrared ranges.

An advantage of using a hollow core optical fiber OF may be that the majority of the radiation guided inside the optical fiber OF is confined to the hollow core HC. Therefore, the majority of the interaction of the radiation inside the optical fiber OF is with the working medium WM, which is provided inside the hollow core HC of the optical fiber OF. As a result, the broadening effects of the working medium WM on the radiation may be increased.

The received input radiation IRD may be electromagnetic radiation. The input radiation IRD may be received as pulsed radiation. For example, the input radiation IRD may comprise a plurality of laser radiation pulses, which may be ultrafast pulses, for example, generated by a laser.

The input radiation IRD may be coherent radiation. The input radiation IRD may be collimated radiation, an advantage of which may be to facilitate and improve the efficiency of coupling the input radiation IRD into the optical fiber OF. The input radiation IRD may comprise a single frequency, or a narrow range of frequencies. The input radiation IRD may be generated by a laser. Similarly, the output radiation ORD may be collimated and/or may be coherent.

The broadband range of the output radiation ORD may be a continuous range, comprising a continuous range of radiation frequencies. The output radiation ORD may comprise supercontinuum radiation. Continuous radiation may be beneficial for use in a number of applications, for example in metrology applications. For example, the continuous range of frequencies may be used to interrogate a large number of properties. The continuous range of frequencies may for example be used to determine and/or eliminate a frequency dependency of a measured property. Supercontinuum output radiation ORD may comprise for example electromagnetic radiation over a wavelength range of 100 nm - 4000 nm. The broadband output radiation ORD frequency range may be for example 400 nm - 900 nm, 500 nm - 900 nm, or 200 nm - 2000 nm. The supercontinuum output radiation ORD may comprise white light.

The input radiation IRD provided by the pulsed pump radiation source PRS may be pulsed. The input radiation IRD may comprise electromagnetic radiation of one or more frequencies between 200 nm and 2 $\mu$m. The input radiation IRD may for example comprise electromagnetic radiation with a wavelength of 1.03 $\mu$m. The repetition rate of the pulsed radiation IRD may be of an order of magnitude of 1 kHz to 100 MHz. The pulse energies may have an order of magnitude of 0.1 $\mu$J to 100 $\mu$J, for example 2.5 $\mu$J - 100 $\mu$J, or 1 $\mu$J - 10 $\mu$J. A pulse duration for the input radiation IRD may be between 10 fs and 10 ps, for example 300 fs. The average power of input radiation IRD may be between 100 mW to several 100 W. The average power of input radiation IRD may for example be 20 - 50 W.

The pulsed pump radiation source PRS may be a laser. The spatio-temporal transmission characteristics of such a laser pulse, e.g. its spectral amplitude and phase, transmitted along the optical fiber OF can be varied and tuned through adjustment of (pump) laser parameters, working component WM variations, and optical fiber OF parameters. Said spatio-temporal transmission characteristics may include one or more of: output power, output mode profile, output temporal profile, width of the output temporal profile (or output pulse width), output spectral profile, and bandwidth of the output spectral profile (or output spectral bandwidth). Said pulse pump radiation source PRS parameters may include one or more of: pump wavelength, pump pulse energy, pump pulse width, pump pulse repetition rate. Said optical fiber OF parameters may include one or more of: optical fiber length, size and shape of the hollow core 101, size and shape of the capillaries, thickness of the walls of the capillaries surrounding the hollow core. Said working medium WM, e.g.

filling gas, parameters may include one or more of: gas type, gas pressure and gas temperature.

The broadband output radiation ORD provided by the radiation source RDS may have an average output power of at least 1 W. The average output power may be at least 5 W. The average output power may be at least 10 W. The broadband output radiation ORD may be pulsed broadband output radiation ORD. The broadband output radiation ORD may have a power spectral density in the entire wavelength band of the output radiation of at least 0.01 mW/nm. The power spectral density in the entire wavelength band of the broadband output radiation may be at least 3 mW/nm.

As described above, a broadband radiation source may be desirable for metrology applications. An example application may be for lithographic applications, such as measurement and inspection of lithographically patterned structures. A broadband radiation source may be provided in a metrology apparatus. The metrology apparatus may be for use in relation to lithographic measurements. The measurements may for example include overlay, alignment, and/or levelling measurements. An advantage of using a broadband radiation source may be that the same source may be used for the different types of measurements.

A broadband radiation source, such as the one described in relation to figure 5 above, may be provided for a metrology application. The broadband source may receive input (pump) radiation IRD from a pump radiation source, for example a seed laser. The pump radiation may be pulsed radiation. The pump radiation may be broadened to broadband radiation. In order to achieve the nonlinear broadening effects described above, high intensity radiation may be required. This may be provided by a pulse radiation source PRS. An example pulsed radiation source may provide pulses with a central wavelength of 1030 nm, a pulse energy E of the order of 10 $\mu$J, average power P in the range of 50 W, and a repetition rate f of approximately 50MHz. The relation between the repetition rate f, pulse energy E and average power P may be approximated as P = f*E. Therefore, for a 10$\mu$J pulse energy and 50W average power, the repetition rate may be 5 MHZ.

In a broadband radiation source, the pump radiation source may form a substantial part of the overall cost of the broadband source. In known implementations of broadband radiation sources as described above the pump source may constitute around 20% of the total cost of the broadband radiation source. The cost of radiation sources may be an important consideration in design and selection of metrology apparatus. The high cost of a broadband radiation source may restrict its applicability. It would therefore be desirable to provide a lower-cost configuration for a broadband radiation source. Specifically, it may be advantageous to design and provide a more cost-effective pump radiation source.

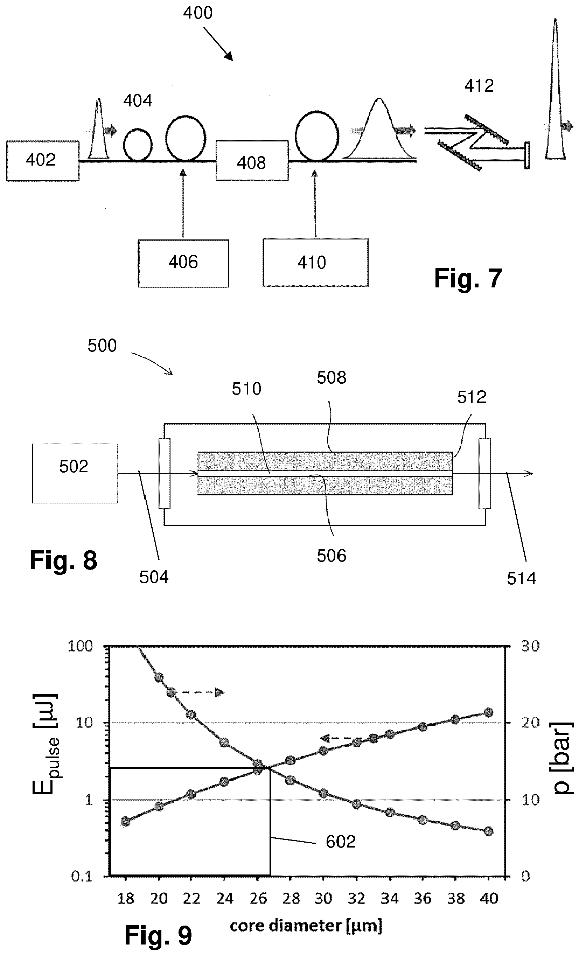

Figure 7 depicts a schematic representation of components of a pulse radiation source 400 for providing input radiation to a hollow core fibre configured for spectral broadening of the input radiation. The pulse radiation source 400 may be an ultrafast high power fiber laser. In the setup, a fiber-based oscillator 402 may provide seed pulses of radiation. The seed pulses may have a pulse length in the range of 100 fs to 500 fs. The seed pulses may be amplified by a chirped-pulse amplification technique before being provided to the hollow-core fibre. The hollow core fiber may be a gas-filled hollow core fiber. The amplification may be performed to reach pulse target energies high enough (e.g. around 10 $\mu$J) to induce non-linear spectral broadening effects inside the hollow-core fiber. The nonlinear effects relied upon to achieve spectral broadening may include modulation instability (MI), also referred to as modulational instability.

Modulation instability is a stochastic non-linear spectral broadening process. MI causes spectral broadening based on naturally occurring variations (or modulations) in the radiation pulse being reinforced through non-linear effects (e.g. Kerr effects). The non-linear effects may be enhanced by the hollow-core fiber by achieving high localised radiation intensities.

Modulation instability may be used to achieve spectral broadening of received pump radiation. Using modulation instability may provide an advantage as it may produce broadband radiation having a relatively flat intensity-wavelength distribution. This may especially be the case if a plurality of pulses are averaged. Due to the relatively flat intensity distribution over a broad wavelength range, a modulation instability driven broadband radiation source may be referred to as a white light source. Another advantage of using MI-driven spectral broadening is that the process is more design robust than soliton self-compression based spectral broadening. This means that small variations in an MI-driven source setup have a relatively small effect on the output radiation compared to a soliton self-compression source. Another advantage may be that modulation instability driven broadening of radiation may be achieved using economical sources as the pump source, relative to other radiation broadening techniques.

In order to amplify the seed pulse, a fibre based pulse stretcher 404 and first amplifier 406 (e.g. a fibre pre-amplifier) may perform a first amplification step of the seed pulses. The first amplifier may be a fiber pre-amplifier, such as for example a conventional Yb-doped single-mode fiber. The first amplifier may increase the pulse energy to approximately 1 $\mu$J. In other example implementations, a first amplifier may be provided that is configured to increase the pulse energy to up to approximately 2.5 $\mu$J. This is a limit for a single amplifier, as nonlinear effects that would occur for greater amplification may result in substantial pulse deterioration and/or irreversible fiber damage.

After the first amplification stage, a down counter 408 may reduce the repetition rate of the pulses, that is to say, reduce the number of pulses per second. The reduction in number of pulses may be to enable a higher energy per pulse whilst keeping the average power of the pulsed radiation the same. A second amplifier 410 (e.g. a fiber power amplifier) may perform a second amplification step to boost the pulse energy to a desired target energy. The target energy may be in a range from 2.5 μJ to (e.g. several) 10s of μJ. the second amplifier 410 may be a fiber power amplifier, such as for example a large-mode-area, Yb-doped photonic crystal fiber. A bulk grating compressor 412 may then compress the pulse to obtain a high energy ultra-short pulse.

The inventors realized that the cost of the pump radiation source 400 could be reduced considerably if the source were able to comprise a single amplifier, instead of the two amplifiers currently required. For this to work, the broadband source would have to produce broadband radiation based on received pump pulses with an energy < 1 μJ. In this case, the second amplifier 410 and the down counter 408 could be removed from the source 400. Such a reduced pulse power may have a further advantage of allowing the source 400 utilize a more cost-effective compressor module (e.g. a prism pair instead of bulk gratings), because the peak intensity is reduced.

Removing the need for a second amplifier 410 and a down counter 408 may result in a significant cost reduction of the pulsed pump radiation source 400 (e.g. 40-50%, excluding housing and periphery). Advantageously, avoiding the second amplifier 410 and down counter 408 modules may reduce the amount of downtime of the source 400, because fewer modules are present that may cause failure.

However, previous implementations of a broadband radiation source relying on modulation instability MI require pulses with an energy greater than 5 μJ to function, because the MI nonlinear optical effects are triggered at these energy levels. In an example previous implementation, a hollow core photonic crystal fiber HC-PCF with an inscribed core diameter of 30 μm may be used. The hollow core may be filled with the working medium/ working gas comprising Krypton at a pressure of 25.7 bar. When pumped with 1030 nm, 300 fs, 5.3 μJ radiation pulses at 5 MHz, a supercontinuum broadband output radiation may be achieved with a low-wavelength cutoff at around 400 nm. This may be referred to as the base setup in the paragraphs below.

In order to achieve the intensities required for MI based nonlinear spectral broadening effects at lower pulse energies, a smaller core diameter may be used. This can be seen from relation (1) below. The relation between the base setup and a setup, referred to as a new setup, with a reduced pulse energy $E_{new}$, may be as follows:

$$E_{new} = E_{base} \left(\frac{D_{new}}{D_{base}}\right)^2 \frac{p_{base}}{p_{new}} \quad (1)$$

where $D_{new}$ and $D_{base}$ are the core diameters of the base setup and new setup hollow core fibers, respectively, $p_{base}$ and $p_{new}$ are the working gas pressures of the base and new setups, and $E_{new}$ and $E_{base}$ are the pulse energies provided to the fiber in the new and base setups.

Therefore, according to an embodiment of the invention, figure 8 depicts a radiation source 500 for generating broadband radiation, comprising a pump source 502 configured to generate pump radiation 504 with a plurality of pulses with a pulse energy of 2.5 μJ or less. The pulse duration may have a range from 100 fs to 500 fs. The pulse may have a soliton order that is higher than 16. The radiation source 500 further comprises a hollow core fiber 508 with a hollow 506 core and a cladding surrounding the hollow core. The hollow core is configured to comprise a working medium 510. The working medium comprises a pressurized gas. The pressurized gas is present within the hollow core of the fiber at least while the radiation source is in use. The hollow core fiber 508 is further arranged to receive the pulsed pump radiation 504 at an input end of the fiber. One or more of the diameter of the hollow core 506 and the pressure of the gas 510 are configured to broaden the spectrum of the pump radiation as it propagates along the fiber to form broadband radiation 514. The broadband radiation 514 is output at an output end 512 of the hollow core fiber 508.

An advantage of the radiation source described above is that it provides broadband radiation using pump source pulses having a lower energy (2.5 μJ or less) than previously achieved for broadband sources having a soliton order that is higher than 16 (N > 16). Preferably, the soliton order is higher than 20 (N > 20) and modulation instability is the dominant nonlinear broadening effect.

The soliton order N of the input pulsed pump radiation is a convenient parameter that can be used to distinguish conditions under which spectral broadening is dominated by modulation instability and conditions under which spectral broadening is dominated by soliton self-compression. Spectral broadening is typically dominated by modulation instability when N > 16, or preferably N > 20. Spectral broadening is typically dominated by soliton self-compression when N < 20, or preferably N < 16.

Therefore, it is an aim of the present invention to provide a high soliton order N (e.g. N > 16, or preferably N > 20). The soliton order of the input pulsed pump radiation is proportional to the pulse duration of the input pulsed pump radiation. Therefore, a pulse duration of 100 fs or more may be used. The soliton order of the input pulsed pump radiation may additionally or alternatively be increased by increasing the pulse energy of the input pulsed pump radiation.

The soliton order N of the input pulsed pump radiation may be used to distinguish conditions under which spectral broadening is dominated by soliton self-compression and conditions under which broadening is dominated by modulation instability. The soliton order N of the input pulse pump radiation may depend on properties of the pulse of pump power. The properties may include the duration of the pulse, the peak power of the pulse, and the group velocity dispersion of the pulse. Specifically, the soliton order N may be expressed as

$$N = \sqrt{\gamma \frac{P_p \tau^2}{|\beta_2|}}$$

where $\gamma$ is a nonlinear phase (or nonlinear parameter), $P_p$ is a pump peak power of the input pulsed pump radiation, $\tau$ is a pump pulse duration of the input pulsed pump radiation, and $\beta_2$ is the group velocity dispersion of the working medium.

In order to enable a high soliton order in combination with a pulse energy of 2.5 $\mu$J or less, the diameter of the hollow core of the fiber may be less than 30 $\mu$m, less than 20 $\mu$m, or less than 10 $\mu$m. The diameter of the hollow core may for example be in a range from 16 $\mu$m to 22 $\mu$m.

Other than determining the ability to achieve spectral broadening through modulation instability, the properties of an inside of the hollow core fiber may also determine the wavelength range of the output broadband radiation. While the broadband radiation source is in use, the pressure of the gas may be set so that the spectrum of the output broadband radiation has a low-wavelength cut-off in a range from 350 nm to 450 nm. The pressure of the gas may be of the order of 10s of bar. The pressure of the gas may for example be in a range from 20 bar to 40 bar. Preferably, the gas pressure may be in a range from 20 bar - 30 bar.

The gas pressure required to achieve a desired low-wavelength cut-off may depend on the diameter of the hollow core. The pressure of the gas may be determined based on a zero-dispersion wavelength ZDW of the hollow core fiber. In the capillary approximation, the ZWD may be obtained from the root of the group velocity dispersion $\beta_2$ :

$$\beta_2(\lambda = \lambda_{ZDW}) \equiv 0$$

with $\beta_2 = \frac{\partial^2 \beta}{\partial \omega^2}$, and $\omega = 2\pi \frac{c}{\lambda}$. In which $\beta_2$ is the group velocity dispersion, $\beta$ is the propagation constant, $\lambda$ is the radiation wavelength, and c is the speed of light in vacuum.

The group velocity dispersion may be approximated as

$$\beta = \frac{2\pi}{\lambda} \sqrt{n_{gas}^2(p,\lambda) - \left(\frac{\lambda}{D}\right)^2 \cdot \left(\frac{u_{01}}{\pi}\right)^2}$$

In which $n_{gas}$ is the refractive index of the pressurized gas, and $u_{01} \approx 2.405$ is the first zero of the Bessel function of the first kind $J_0$. The ZDW may be in a range from 700nm to 1000 nm. For the base setup described above, the ZDW can be estimated to be 909.8 nm.

Alternatively and/or additionally to the ZDW, the pressure of the gas may be determined based on a phase-matching wavelength $\lambda_{PM}$ of the hollow core fiber. The phase matching wavelength may be determined based in the formula

$$\beta_{PM}(\lambda = \lambda_{PM}) - \beta_{sol}(\omega) = 0$$

with

$$\beta_{sol}(\omega) \equiv \beta(\omega_{pump}) + \beta_1(\omega_{pump}) \cdot [\omega - \omega_{pump}] + \frac{\gamma P_c}{2}$$

and

$$\omega_{pump} = 2\pi \frac{c}{\lambda}, \beta_1 = \frac{\partial \beta}{\partial \omega}$$

In which $\beta_{PM}$ is the linear propagation constant at the phase matching wavelength. $\beta_{sol}$ is the propagation constant of a soliton at the pump frequency $\omega_{pump}$, c is the speed of light in vacuum, $\gamma$ is a nonlinear parameter quantifying the strength of the nonlinear effect, which may also be referred to as the nonlinear coefficient, or the nonlinear phase. $P_c$ is the peak power of a compressed soliton. The phase matching wavelength may be in a range from 300 nm to 700 nm.

Figure 9 depicts an example graph of the estimated pulse energy and gas pressure for a given core diameter, for a hollow core fiber of a radiation source discussed herein. The graph indicates the relation between the core diameter, gas pressure, and pulse energy for the criterion that the ZDW stays constant (e.g. at 909.8 nm). The arrows on the lines in the graph indicate which axis the lines are scaled against. The graph was determined using Xenon as a pressurised gas in the estimated calculation. From the graph in figure 9 it can be seen that the pressure increases as the core diameter decreases. The pulse energy increases as the core diameter increases. Area 602 indicates a usable core diameter range. The diameter range may be determined based on the maximum acceptable pulse energy. In figure 9, this may be set to 2.5μJ. In other example implementations, the maximum energy pulse may be limited to 1μJ.

As can be seen from the graph, a core diameter of around 27 $\mu$m may allow a pulse energy of 2.5 $\mu$m or less to be used. A core diameter D around 21 $\mu$m may allow a pulse energy of 1 $\mu$J or less to be used. The graph illustrates that for reducing core diameters, the required gas pressure increases rapidly. Such large gas pressures may be less practical (e.g. engineering or safety challenges), or even impossible (e.g. Xe becomes supercrititcal for pressures > 58 bar).

The hollow core fiber 508 used in the radiation source 500 may be a fiber as described in relation to figures 4 and/or 6. The hollow core fiber 508 may be a hollow core photonic crystal fiber HC-PCF. The cladding of the fiber may comprise a plurality of capillaries. The capillaries may be arranged in a single ring surrounding the hollow core. The capillaries may have a wall surrounding a hollow capillary core. The wall may have a thickness of around 200 nm or less. The hollow core fiber may be provided separately from the pump source of the radiation source.

The radiation source 500 may have at least its ends contained in a reservoir, as described in relation to figure 5 above. The reservoir may be for providing the gas to the hollow core of the fiber. The reservoir may have a controller for controlling properties of the gas. The reservoir may control the pressure and/or consistency of the gas.

The pump source 502 for the radiation source 500 may comprise a laser. The pump source 502 may comprise a seed laser followed by a single amplifier. Specifically, the pump source does not require a down counter 408 or second amplifier 410, thereby reducing the cost and number of components of the pump source 502 and the radiation source 500. The single amplifier may be a fiber amplifier. As a result of no down counter 408 being present, the repetition rate of the pulsed output broadband radiation 514 may be the equal to the repetition rate of the seed laser of the pump source 502.

The pump source may comprise a pulse compressor downstream of the first amplifier. The pulse compressor may be directly downstream of the first amplifier. The pulse compressor may comprise one or more prism pairs.

The radiation source 500 described herein may be provided in a metrology apparatus. The metrology apparatus may be for measurement and/or inspection of lithographic structures. The radiation source may be provided in a lithographic apparatus, and/or a litho-cell.

The features of the different aspects, embodiments and implementations described herein may be combined, unless a specifically stated otherwise.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Further embodiments are disclosed in the list of numbered clauses below:

    1. A radiation source for generating broadband radiation, and comprising:

        a pump source configured to generate pump radiation comprising a plurality of radiation pulses having a pulse energy of 2.5 $\mu$J or less; and
        a hollow core fiber comprising a hollow core and a cladding surrounding the hollow core, the hollow core having a pressurized gas therein, and the hollow core fiber being arranged to receive, at an input end, the pump radiation;

wherein one or more of a diameter of the hollow core and a pressure of the gas is configured such that the radiation pulse has a soliton order that is higher than 16 so as to broaden a spectrum of the pump radiation using modulation instability as the pump radiation propagates along the hollow-core fiber, for providing output broadband radiation from an output end of the hollow core fiber.

2. A radiation source according to clause 1, wherein the diameter of the hollow core is less than 30 μm, less than 20 μm or less than 10 μm.

3. A radiation source according to clause 1 or 2, wherein the diameter of the hollow core is in a range from 16 μm to 22 μm.

4. A radiation source according to any of the preceding clauses, wherein the pulse duration is in a range from 100 s to 500 fs.

5. A radiation source according to any preceding clause, wherein the pressure of the gas is configured to provide a spectrum of the output broadband radiation having a low-wavelength cut-off in a range from 350 nm to 450 nm, given a particular hollow core diameter.

6. A radiation source according to clause 5, wherein the pressure of the gas is in a range from 20 bar to 40 bar.

7. A radiation source according to clause 5 or 6, wherein the pressure of the gas is determined based on a zero-dispersion wavelength of the hollow core fiber.

8. A radiation source according to clause 7, wherein the zero-dispersion wavelength is determined based on the formula:

$$\beta_2(\lambda = \lambda_{\mathrm{ZDW}}) \equiv 0$$

with

$$\beta_2 = \frac{\partial^2 \beta}{\partial \omega^2} \ and \ \omega = 2\pi \frac{c}{\lambda}$$

where $\beta$ is a propagation constant, $\lambda$ is wavelength and c is the speed of light in vacuum.

9. A radiation source according to clause 7 or 8, wherein the zero-dispersion wavelength is in a range from 700 nm to 1000 nm.

10. A radiation source according to clause 5 or 6, wherein the pressure of the gas is determined based on a phase-matching wavelength of the hollow core fiber.

11. A radiation source according to clause 10, wherein the phase-matching wavelength $\lambda_{\mathrm{PM}}$ is determined based on the formula:

$$\beta_{\mathrm{PM}}(\lambda = \lambda_{\mathrm{PM}}) - \beta_{\mathrm{sol}}(\omega) = 0$$

with

$$\beta_{\mathrm{sol}}(\omega) \equiv \beta(\omega_{\mathrm{pump}}) + \beta_1(\omega_{\mathrm{pump}}) \cdot [\omega - \omega_{\mathrm{pump}}] + \frac{\gamma P_c}{2}$$

and

$$\omega_{\mathrm{pump}} = 2\pi \frac{c}{\lambda} \ , \beta_1 = \frac{\partial \beta}{\partial \omega}$$

where $\beta_{\mathrm{PM}}$ is a linear propagation constant at the phase matching wavelength, $\beta_{\mathrm{sol}}$ is a propagation constant of a soliton at pump frequency $\omega_{pump}$, c is the speed of light in vacuum, $\gamma$ is a nonlinear parameter, and $P_c$ is a peak power of a compressed soliton.

12. A radiation source according to clause 10 or 11, wherein the phase-matching wavelength is in a range from 300 to 700 nm.

13. A radiation source according to any preceding clause, wherein the pump source comprises:

a seed laser configured to provide seed radiation pulses; and
a fiber amplifier configured to receive and amplify the seed radiation pulses, and to provide the pump radiation to the hollow core fiber.

14. A radiation source according to clause 13, wherein the pump source further comprises:
a pulse compressor located downstream, and optionally directly downstream, of the fiber amplifier.

15. A radiation source according to clause 13 or 14, wherein the pulse compressor comprises one or more prism pairs.

16. A radiation source according to any of clauses 13 to 15, wherein the seed laser pulses have a first repetition rate, and the output broadband radiation of the radiation source comprises pulses with a second repetition rate, wherein the first repetition rate is substantially equal to the second repetition rate.

17. A radiation source according to any preceding clause, wherein the pump source comprises only a single fiber amplifier.

18. A radiation source according to any preceding clause, wherein the hollow core fiber is a hollow core photonic crystal fiber, HC-PCF.

19. A radiation source according to clause 18, wherein the hollow core of the photonic crystal fibre is surrounded by a cladding comprising a plurality of capillaries.

20. A radiation source according to clause 19, wherein a thickness of a wall portion of the capillaries in the HC-PCF is 200 nm or less.

21. A radiation source according to any of clauses 18 to 20, wherein the HC-PCF is a single-ring HC-PCF.

22. A hollow core photonic crystal fiber (HC-PCF) for receiving one or more pulses of pump radiation having an energy of 2.5 $\mu$J or less, the HC-PCF being configured such that the one or more pulses of pump radiation have a soliton order that is higher than 16 so as to broaden a spectrum of the pump radiation using modulation instability as the pump radiation propagates along the fiber, the fiber comprising:

a hollow core having a diameter in a range from 16 $\mu$m to 22 $\mu$m; and
a cladding surrounding the hollow core;
wherein the hollow core is configured to receive a pressurized gas therein.

23. A HC-PCF according to clause 22, wherein the HC-PCF is a single-ring HC-PCF.

24. A HC-PCF according to clause 22 or 23, wherein a thickness of a wall portion of the capillaries in the HC-PCF is around 200 nm or less.

25. A HC-PCF according to any of clauses 22 to 24, wherein the hollow core is filled with a gas at a pressure in a range from 20 bar to 40 bar.

26. A radiation source for generating broadband radiation, and comprising:

a pump source configured to generate pump radiation comprising a plurality of radiation pulses having a pulse energy of 2.5 $\mu$J or less; and
a hollow core fiber comprising a hollow core and a cladding surrounding the hollow core, the hollow core having a pressurized gas therein, and the hollow core fiber being arranged to receive, at an input end, the pump radiation and to emit, at an output end, output broadband radiation,
wherein a diameter of the hollow core is in a range from 16 $\mu$m to 22 $\mu$m; and
the pump radiation pulses have a soliton order that is higher than 16.

27. A radiation source for generating broadband radiation, and comprising:

a pump source configured to generate pump radiation comprising a plurality of radiation pulses having a pulse energy of 2.5 $\mu$J or less; and
a hollow core fiber comprising a hollow core and a cladding surrounding the hollow core, the hollow core configured to have a pressurized gas therein, and the hollow core fiber being arranged to receive, at an input end, the pump radiation;
a reservoir configured to control and deliver the pressurized gas to the hollow core fiber;
wherein one or more of a diameter of the hollow core and a pressure of the pressurized gas is configured such that the radiation pulse has a soliton order that is higher than 16 so as to broaden a spectrum of the pump radiation using modulation instability as the pump radiation propagates along the hollow-core fiber, for providing output broadband radiation from an output end of the hollow core fiber.

28. A lithographic apparatus comprising the radiation source according to any of clauses 1 to 21 and 26 to 27, and/or comprising the HC-PCF according to any of clauses 22 to 25.

29. A litho-cell comprising the lithographic apparatus according to clause 28.

30. A method for generating broadband radiation, the method comprising:

generating, by a pump source, pump radiation comprising a plurality of radiation pulses having a pulse energy of 2.5 μJ or less; and

receiving the pump radiation at an input end of a hollow core fiber, the hollow core fiber comprising a hollow core and a cladding surrounding the hollow core, the hollow core having a pressurized gas therein, and one or more of a diameter of the hollow core and a pressure of the gas being configured such that radiation pulse has a soliton order that is higher than 16 so as to broaden a spectrum of the pump radiation using modulation instability as the pump radiation propagates along the hollow-core fiber; and

providing output broadband radiation from an output end of the hollow core fiber.

31. A method for generating broadband radiation, the method comprising:

generating, by a pump source, pump radiation comprising a plurality of radiation pulses having a pulse energy of 2.5 μJ or less;

receiving the pump radiation at an input end of a hollow core fiber, the hollow core fiber comprising a hollow core and a cladding surrounding the hollow core, the hollow core having a diameter in a range from 16 μm to 22 μm and having a pressurized gas therein, the hollow core fiber being configured such that the radiation pulses have a soliton order that is higher than 16 so as to broaden a spectrum of the pump radiation using modulation instability as the pump radiation propagates along the hollow-core fiber; and providing output broadband radiation from an output end of the hollow core fiber.

The skilled person will be able to envisage other embodiments without departing from the scope of the appended claims.

**Claims**

1.   A radiation source for generating broadband radiation, and comprising:

a pump source configured to generate pump radiation comprising a plurality of radiation pulses having a pulse energy of 2.5 μJ or less; and

a hollow core fiber comprising a hollow core and a cladding surrounding the hollow core, the hollow core having a pressurized gas therein, and the hollow core fiber being arranged to receive, at an input end, the pump radiation; wherein one or more of a diameter of the hollow core and a pressure of the gas is configured such that the radiation pulse has a soliton order that is higher than 16 so as to broaden a spectrum of the pump radiation using modulation instability as the pump radiation propagates along the hollow-core fiber, for providing output broadband radiation from an output end of the hollow core fiber.

2.   A radiation source according to claim 1, wherein the diameter of the hollow core is less than 30 μm, less than 20 μm or less than 10 μm.

3.   A radiation source according to claim 1, wherein the diameter of the hollow core is in a range from 16 μm to 22 μm.

4.   A radiation source according to any of the preceding claims, wherein the pulse duration is in a range from 100 s to 500 fs.

5.   A radiation source according to any preceding claim, wherein the pressure of the gas is configured to provide a spectrum of the output broadband radiation having a low-wavelength cut-off in a range from 350 nm to 450 nm, given a particular hollow core diameter.

6.   A radiation source according to claim 5, wherein the pressure of the gas is in a range from 20 bar to 40 bar.

7.   A radiation source according to claim 5 or 6, wherein the pressure of the gas is determined based on a phase-matching wavelength of the hollow core fiber.

8.   A radiation source according to any preceding claim, wherein the pump source comprises:

a seed laser configured to provide seed radiation pulses; and
a fiber amplifier configured to receive and amplify the seed radiation pulses, and to provide the pump radiation to the hollow core fiber.

9. A radiation source according to claim 8, wherein the pump source further comprises a pulse compressor located downstream of the fiber amplifier.

10. A radiation source according to claim 8 or 9, wherein the seed laser pulses have a first repetition rate, and the output broadband radiation of the radiation source comprises pulses with a second repetition rate, wherein the first repetition rate is substantially equal to the second repetition rate.

11. A radiation source according to any preceding claim, wherein the pump source comprises only a single fiber amplifier.

12. A radiation source according to any preceding claim, wherein the hollow core fiber is a hollow core photonic crystal fiber, HC-PCF.

13. A hollow core photonic crystal fiber (HC-PCF) for receiving one or more pulses of pump radiation having an energy of 2.5 $\mu$J or less, the HC-PCF being configured such that the one or more pulses of pump radiation have a soliton order that is higher than 16 so as to broaden a spectrum of the pump radiation using modulation instability as the pump radiation propagates along the fiber, the fiber comprising:

a hollow core having a diameter in a range from 16 $\mu$m to 22 $\mu$m; and
a cladding surrounding the hollow core;
wherein the hollow core is configured to receive a pressurized gas therein.

14. A method for generating broadband radiation, the method comprising:

generating, by a pump source, pump radiation comprising a plurality of radiation pulses having a pulse energy of 2.5 $\mu$J or less; and
receiving the pump radiation at an input end of a hollow core fiber, the hollow core fiber comprising a hollow core and a cladding surrounding the hollow core, the hollow core having a pressurized gas therein, and one or more of a diameter of the hollow core and a pressure of the gas being configured such that radiation pulse has a soliton order that is higher than 16 so as to broaden a spectrum of the pump radiation using modulation instability as the pump radiation propagates along the hollow-core fiber; and
providing output broadband radiation from an output end of the hollow core fiber.

15. A method for generating broadband radiation, the method comprising:

generating, by a pump source, pump radiation comprising a plurality of radiation pulses having a pulse energy of 2.5 $\mu$J or less;
receiving the pump radiation at an input end of a hollow core fiber, the hollow core fiber comprising a hollow core and a cladding surrounding the hollow core, the hollow core having a diameter in a range from 16 $\mu$m to 22 $\mu$m and having a pressurized gas therein, the hollow core fiber being configured such that the radiation pulses have a soliton order that is higher than 16 so as to broaden a spectrum of the pump radiation using modulation instability as the pump radiation propagates along the hollow-core fiber; and providing output broadband radiation from an output end of the hollow core fiber.

# Fig. 1

**Fig. 2**

LC

SC x 4

SCS

I/O1

BK CH BK CH

LACU

RO

TCU LB LA

I/O2

CH BK CH BK

DE x 4

**Fig. 3**

LA

SC1

SC3

CL

0

-1 +1

MT

SC2

Fig. 4

Fig. 5

(a)

Fig. 6

(b)

Fig. 7

Fig. 8

Fig. 9

Europäisches
Patentamt

European
Patent Office

Office européen
des brevets

# EUROPEAN SEARCH REPORT

Application Number

EP 21 15 2056

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 3 758 168 A1 (ASML NETHERLANDS BV [NL]) 30 December 2020 (2020-12-30) * paragraphs [0001], [0050], [0051], [0054], [0055], [0056], [0057] * * figure 8 * | 1-15 | INV. G02F1/35 G03F1/00 G03F1/50 G02F1/365 G03F7/20 H01S3/00 |
| Y | EP 2 942 847 A1 (MAX PLANCK GES ZUR FÖRDERUNG DER WISSENSCHAFTEN E V [DE]) 11 November 2015 (2015-11-11) * paragraphs [0006], [0011], [0024], [0033], [0048] - [0052] * | 1-15 | |
| A | EP 3 715 945 A1 (ASML NETHERLANDS BV [NL]) 30 September 2020 (2020-09-30) * paragraphs [0033], [0149] * | 2,4 | |
| Y | M. AZHAR ET AL: "Raman-free nonlinear optical effects in high pressure gas-filled hollow core PCF", OPTICS EXPRESS, vol. 21, no. 4, 25 February 2013 (2013-02-25), page 4405, XP055246506, US ISSN: 2161-2072, DOI: 10.1364/OE.21.004405 | 3,6 | TECHNICAL FIELDS SEARCHED (IPC) H01S G03F G02F |
| A | * page 4406, paragraph 2 * * figure 1 * * abstract * | 4 | |
| Y | EP 1 949 151 A2 (OMNI SCIENCES INC [US]) 30 July 2008 (2008-07-30) * paragraphs [0008], [0020] * | 8,11 | |
| A,D | US 9 160 137 B1 (ABDOLVAND AMIR [DE] ET AL) 13 October 2015 (2015-10-13) * figures 1-9 * * abstract * | 1-15 | |

The present search report has been drawn up for all claims

| Place of search | Date of completion of the search | Examiner |
|---|---|---|
| The Hague | 30 June 2021 | Votini, Stefano |

EPO FORM 1503 03.82 (P04C01)

**ANNEX TO THE EUROPEAN SEARCH REPORT
ON EUROPEAN PATENT APPLICATION NO.**

EP 21 15 2056

This annex lists the patent family members relating to the patent documents cited in the above-mentioned European search report.
The members are as contained in the European Patent Office EDP file on
The European Patent Office is in no way liable for these particulars which are merely given for the purpose of information.

30-06-2021

| Patent document cited in search report | | Publication date | Patent family member(s) | | Publication date |
|---|---|---|---|---|---|
| EP 3758168 | A1 | 30-12-2020 | EP | 3758168 A1 | 30-12-2020 |
| | | | WO | 2020259972 A1 | 30-12-2020 |
| EP 2942847 | A1 | 11-11-2015 | DK | 2942847 T3 | 12-08-2019 |
| | | | DK | 3531514 T3 | 21-09-2020 |
| | | | EP | 2942847 A1 | 11-11-2015 |
| | | | EP | 3531514 A1 | 28-08-2019 |
| EP 3715945 | A1 | 30-09-2020 | EP | 3715945 A1 | 30-09-2020 |
| | | | TW | 202102886 A | 16-01-2021 |
| | | | US | 2020310251 A1 | 01-10-2020 |
| | | | WO | 2020193075 A1 | 01-10-2020 |
| EP 1949151 | A2 | 30-07-2008 | CA | 2623380 A1 | 31-05-2007 |
| | | | CA | 2838355 A1 | 31-05-2007 |
| | | | EP | 1949151 A2 | 30-07-2008 |
| | | | US | 2009028193 A1 | 29-01-2009 |
| | | | US | 2009204110 A1 | 13-08-2009 |
| | | | US | 2012239013 A1 | 20-09-2012 |
| | | | US | 2014001364 A1 | 02-01-2014 |
| | | | US | 2014233035 A1 | 21-08-2014 |
| | | | US | 2015008344 A1 | 08-01-2015 |
| | | | US | 2015247756 A1 | 03-09-2015 |
| | | | US | 2016010971 A1 | 14-01-2016 |
| | | | US | 2016363482 A1 | 15-12-2016 |
| | | | US | 2017336258 A1 | 23-11-2017 |
| | | | US | 2019056266 A1 | 21-02-2019 |
| | | | US | 2020064189 A1 | 27-02-2020 |
| | | | WO | 2007061732 A2 | 31-05-2007 |
| US 9160137 | B1 | 13-10-2015 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 2004015085 A1
- WO 2017032454 A1
- WO 2018127266 A1
- US 9160137 B1